(19) **Europäisches Patentamt / European Patent Office / Office européen des brevets**

(11) **EP 1 947 833 A2**

(12) **EUROPEAN PATENT APPLICATION**

(43) Date of publication:
**23.07.2008 Bulletin 2008/30**

(51) Int Cl.:
*H04M 19/00* *(2006.01)*

(21) Application number: **07116410.7**

(22) Date of filing: **14.09.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **18.01.2007 JP 2007009557**

(71) Applicant: **Fujitsu Ltd.**
**Kawasaki-shi, Kanagawa 211-8588 (JP)**

(72) Inventors:
• **Hirahara, Minoru,**
c/o FUJITSU LIMITED
**Kawasaki-shi, Kanagawa 211-8588 (JP)**
• **Miyachika, Eiji,**
c/o FUJITSU LIMITED
**Kawasaki-shi, Kanagawa 211-8588 (JP)**

(74) Representative: **Giles, Ashley Simon et al**
**Haseltine Lake**
**Lincoln House**
**300 High Holborn**
**London WC1V 7JH (GB)**

(54) **Power supply device and method of supplying power supply voltage to load device**

(57)    A power supply device that reduces the loss of a load device, such as an amplifier, which is a supply destination of a power supply voltage. The power supply device includes a controller (14) for controlling a power supply voltage supplied to a load device (12) variably in accordance with an input voltage of the load device (12) (output of a signal source (13)).

FIG.1

Description

Background of the Invention

1. Field of the Invention

The present invention relates to a power supply device supplying voltage to a load device and to a method of supplying power supply voltage to the load device.

2. Description of the Related Art

Power supply devices include a device outputting a constant voltage and a device outputting voltage that changes over time. The present invention is of the latter type. In this field, a technology to control the loss in a load device (such as an amplifier) to which the voltage is supplied is known.
For example, Japanese Patent Application Publication No. 2001-69241 "Circuit For Transmitting Ringer Signal" discloses a ringer signal transmission apparatus for transmitting a ringer signal. The ringer signal transmission apparatus reduces the loss of an amplifier circuit by synchronizing a power supply voltage supplied to the amplifier circuit amplifying a ringer signal with the amplitude of the ringer signal and changing the power supply voltage continuously.

Summary of the Invention

It is desirable to provide a power supply device that can reduce the loss of a load device such as an amplifier that is a supply destination of the power supply voltage.
The power supply apparatus of the present invention is a power supply device supplying a power supply voltage to a load device such as an amplifier and comprises control means for controlling the power supply voltage supplied to the load device variably in a stepwise manner according to an input voltage of the load device.
In a load device such as an amplifier with an output voltage being proportional to an input voltage, the output voltage can be predicted by referencing to the input voltage. Therefore, by controlling the power supply voltage variably so as to reduce the difference from the input voltage (output voltage), it is possible to reduce the difference between the power supply voltage supplied to the load device and the output voltage of the load device, and the loss of the load device can be reduced.
According to the present invention, it is possible to reduce the loss of load devices that are a supply destination of the power supply voltage. Consequently, it is possible to extend the device lifetime as well as to reduce power consumption of the load device, and reduction in size, weight and cost of the load device can be realized.

Brief description of the Drawings

Fig. 1 illustrates an overview configuration of a power supply circuit relating to the first embodiment of the present invention.
Fig. 2 illustrates a more detailed configuration of the power supply circuit of Fig. 1
Fig. 3 is a diagram showing the results of a simulation of power supplied to the amplifier under the condition that the power supply voltage supplied to the amplifier changes in a stepwise manner and under the condition that the power supply voltage supplied to the amplifier is constant (25V).
Fig. 4 is a diagram showing the results of a simulation of power supplied to the amplifier under the condition that the power supply voltage supplied to the amplifier changes in a stepwise manner and under the condition that the power supply voltage supplied to the amplifier is constant (25V).
Fig. 5 shows a first modification of the power supply circuit of the first embodiment according to the present invention.
Fig. 6 shows a second modification of the power supply circuit of the first embodiment according to the present invention.
Fig. 7 illustrates a more detailed configuration of the power supply circuit of Fig. 6.
Fig. 8 is a flowchart illustrating a processing carried out by the controller in the second modification of the first embodiment according to the present invention.
Fig. 9 illustrates an example of a timing diagram of the operation of switches in the power supply circuit which control the level on the power supply voltage based on the processing carried out by the controller in the flowchart in Fig. 8.
Fig. 10 is a diagram of an overview configuration of the power supply circuit relating to the second embodiment of the present invention.

Fig. 11 shows a first modification of the power supply circuit of the second embodiment according to the present invention.

Fig. 12 shows a second modification of the power supply circuit of the second embodiment according to the present invention.

Fig. 13 shows a third modification of the power supply circuit of the second embodiment according to the present invention.

Fig. 14 is a diagram showing another method for determining the decrease of the power supply voltage supplied to the amplifier in the configuration where a load resistor and a switch are added.

Fig. 15 shows a fourth modification of the power supply circuit of the second embodiment according to the present invention.

Fig. 16 is a diagram showing further details of the main part of Fig. 15.

DETAILED DESCRIPTION OF PREFERRED EMBODIMENTS

In the following description, details of the preferred embodiments of the present invention will be described with reference to the accompanying drawings.

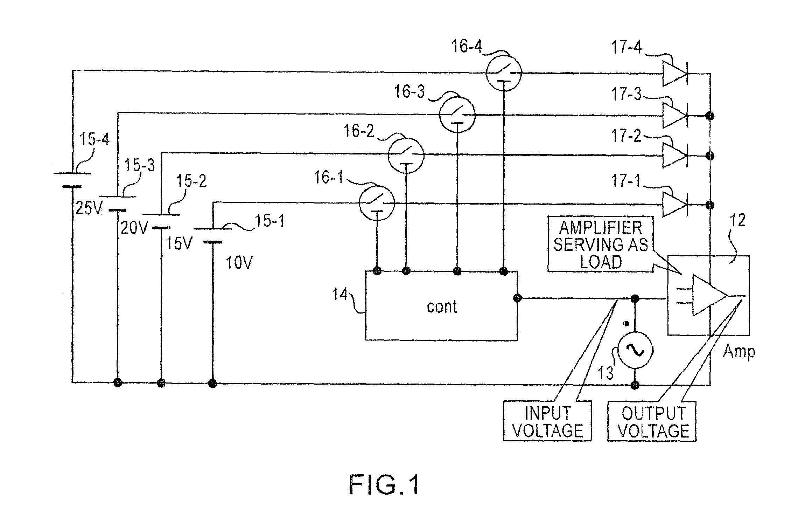

Fig. 1 is a diagram of an overview configuration of a power supply circuit relating to the first embodiment of the present invention. The power supply circuit supplies a power supply voltage to an amplifier 12 that serves as a load.

The power supply circuit comprises a signal source 13 for outputting a signal that changes periodically or aperiodically, an amplifier 12 and a controller 14 that input the output of the signal source 13, DC voltage supplies 15-1, 15-2, 15-3 and 15-4 arranged in parallel, switches (transistors) 16-1, 16-2, 16-3 and 16-4 that correspond to the respective DC voltage supplies, and diodes 17-1, 17-2, 17-3 and 17-4 provided in the subsequent stage of each switch for rectification.

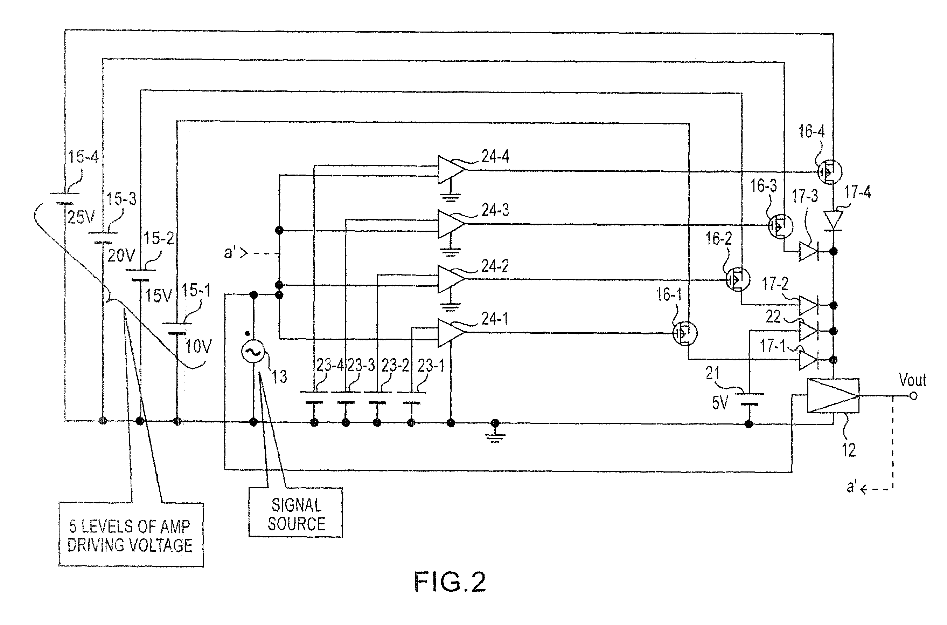

Fig. 2 is a diagram showing a further detailed configuration of the power supply circuit of Fig. 1.

Fig. 2 shows a configuration of the controller 14 of Fig. 1. In Fig. 2, compared with Fig. 1, a DC power supply 21 generating a voltage supplied as a default value to the amplifier 12 that serves as a load and a diode 22 provided to the subsequent stage of the DC power supply 21 for rectification are additionally provided.

In Fig. 2, the DC voltage supplies 15-1, 15-2, 15-3 and 15-4 are arranged in parallel and generate voltages of 10V, 15V, 20V, and 25V, respectively, for example. The default value of the voltage that the DC power supply 21 generates is set to be smaller than the minimum voltage value of the voltage values generated by the DC voltage supplies 15-1, 15-2, 15-3 and 15-4 arranged in parallel. In this example, the voltage value generated by the DC voltage supply 21 is set to 5V. As a result, any of the five level voltages of 5V, 10V, 15V, 20V and 25V are supplied as a power supply voltage to the amplifier 12 that serves as a load.

It should be noted that in the present embodiment, the output voltage $V_{out}$ of the load circuit (amplifier 12) is proportional to the input voltage in the load circuit (amplifier 12), and it is possible to predict the output voltage on the basis of the value of the input voltage.

As shown in Fig. 2, the controller 14 comprises comparators 24-1, 24-2, 24-3 and 24-4. The comparator 24-1 compares a voltage that is a threshold of the output of a DC voltage supply 23-1 with a voltage output from the signal source 13, and outputs a signal to the switch 16-1 to allow the switch (transistor) 16-1 to conduct, if the output voltage of the signal source 13 is equal to or higher than the output threshold voltage of the DC voltage supply 23-1.

The comparator 24-2 compares a voltage that is a threshold of the output of a DC voltage supply 23-2 and a voltage output from the signal source 13, and outputs a signal to the switch 16-2 to allow the switch (transistor) 16-2 to conduct, if the output voltage of the signal source 13 is equal to or higher than the output threshold voltage of the DC voltage supply 23-2.

The comparator 24-3 compares a voltage that is a threshold of the output of a DC voltage supply 23-3 and a voltage output from the signal source 13, and outputs a signal to the switch 16-3 to allow the switch (transistor) 16-3 to conduct, if the output voltage of the signal source 13 is equal to or higher than the output threshold voltage of the DC voltage supply 23-3.

The comparator 24-4 compares a voltage that is a threshold of the output of a DC voltage supply 23-4 and a voltage output from the signal source 13, and outputs a signal to the switch 16-4 to allow the switch (transistor) 16-4 to conduct, if the output voltage of the signal source 13 is equal to or higher than the output threshold voltage of the DC voltage supply 23-4.

It should also be noted that in the present embodiment, as shown in Fig. 2, the output voltage $V_{out}$ of the load circuit (amplifier 12) can be feedback (a'-a) such that it is compared to the output threshold voltages of the DC voltage supplies 23-1 - 23-4 in the comparators 24-1 - 24-4, respectively, in order determine the power supply voltage that is supplied to the load circuit (amplifier 12).

The voltage (threshold) that the DC voltage supply 23-1 outputs is set to be a slightly smaller value (e.g. 4.5V) than the default voltage (5V) output by the DC voltage supply 21 that outputs the default value voltage.

The voltage (threshold) that the DC voltage supply 23-2 outputs is set to be a slightly smaller value (e.g. 9.5V) than the voltage output by the DC voltage supply 15-1 (10V).

The voltage (threshold) that the DC voltage supply 23-3 outputs is set to be a slightly smaller value (e.g. 14.5V) than the voltage output by the DC voltage supply 15-2 (15V).

The voltage (threshold) that the DC voltage supply 23-4 outputs is set to be a slightly smaller value (e.g. 19.5V) than the voltage output by the DC voltage supply 15-3 (20V).

It should be noted that when the voltage value output by the DC voltage supply 23-4 is set in the manner described above, the effective value of the voltage that the signal source 13 outputs has to be limited to a value smaller than $25V/\sqrt{2}$=approximately 17.677 in order to operate the power supply circuit effectively. For example, when a voltage with its effective value being 17V is output from the signal source 13, the maximum amplitude is $17 \times \sqrt{2}$=approximately 24V.

When the voltage that the signal source 13 outputs gradually increases, the power supply circuit performs the following operations. That is, when the voltage output by the signal source 13 exceeds the default value voltage (5V) output by the DC voltage supply 21, the voltage output by the DC voltage supply 15-1 (10V) can be supplied to the amplifier 12 as a power supply voltage. When the voltage output by the signal source 13 exceeds the voltage output by the DC voltage supply 15-1 (10V), the voltage output by the DC voltage supply 15-2 (15V) can be supplied to the amplifier 12 as a power supply voltage.

When the voltage output by the signal source 13 exceeds the voltage output by the DC voltage supply 15-2 (15V), the voltage output by the DC voltage supply 15-3 (20V) can be supplied to the amplifier 12 as a power supply voltage. When the voltage output by the signal source 13 exceeds the voltage output by the DC voltage supply 15-3 (20V), the voltage output by the DC voltage supply 15-4 (25V) can be supplied to the amplifier 12 as a power supply voltage.

Additionally, when the voltage output by the signal source 13 gradually decreases, the power supply circuit performs the following operations. That is, when the voltage output by the signal source 13 falls below the output threshold voltage of the DC voltage supply 23-4, which is slightly lower than the voltage output by the DC voltage supply 15--3 (20V), the voltage output by the DC voltage supply 15-3 (20V) can be supplied to the amplifier 12 as a power supply voltage. When the voltage output by the signal source 13 falls below the output threshold voltage of the DC voltage supply 23-3, which is slightly lower than the voltage output by the DC voltage supply 15-2 (15V), the voltage output by the DC voltage supply 15-2(15V) can be supplied to the amplifier 12 as a power supply voltage.

When the voltage output by the signal source 13 falls below the output threshold voltage of the DC voltage supply 23-2, which is slightly lower than the voltage output by the DC voltage supply 15-1 (10V), the voltage output by the DC voltage supply 15-1(10V) can be supplied to the amplifier 12 as a power supply voltage. When the voltage output by the signal source 13 falls below the output threshold voltage of the DC voltage supply 23-1, which is slightly lower than the voltage output by the DC voltage supply 21(5V), the voltage output by the DC voltage supply 21 (5V) can be supplied to the amplifier 12 as a power supply voltage.

In the following description, a case that the power supply voltage supplied to the amplifier changes in a stepwise manner is compared with a case that the power supply voltage supplied to the amplifier is constant (25V) in terms of the amount of voltage that the power supply circuit expends in the load circuit (amplifier 12).

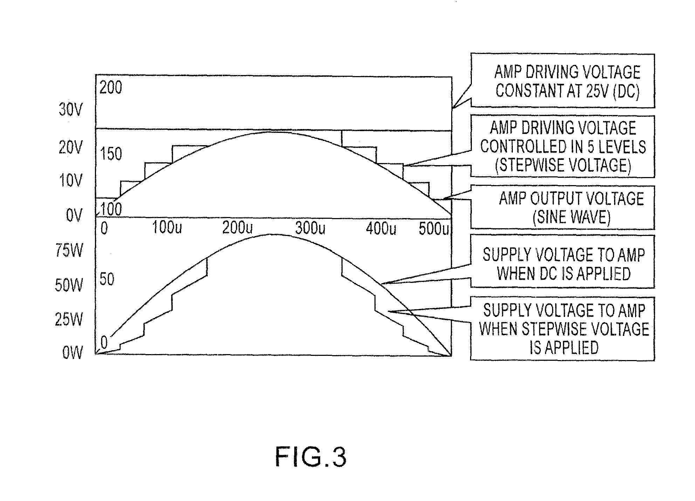

Fig. 3 is a diagram (1) showing the results of a simulation of power supplied to the amplifier under the condition that the power supply voltage supplied to the amplifier changes in a stepwise manner and under the condition that the power supply voltage supplied to the amplifier is constant (25V).

Fig. 3 assumes that the maximum amplitude of the input signal of the amplifier (output of the signal source) is approximately the same as the maximum value of the voltage that can be output from the power supply circuit.

Given that the effective value Vo of the input signal of the amplifier is 17Vrms and the load resistance of the amplifier is 7Ω, the current Io, flowing into the amplifier is 17Vrms/7Ω. When the power supply voltage supplied to the amplifier is Vin the power P supplied to the amplifier can be represented in the following equation.

$$P = V_{in} \times I_o \quad \dots \quad (1)$$

According to the above equation (1), each of the supplied power P (DC) in a case of the power supply voltage supplied to the amplifier being a constant value (25V) and the supplied power P(stepwise) in a case of the power supply voltage supplied to the amplifier changing in a stepwise manner is calculated as follows.

P(DC)=60.7W

P(stepwise)=55.6W

The output power Po of the amplifier can be represented by the following equation.

$$P_o = V_o \times I_o \quad \dots \quad (2)$$

According to the above equation (2), the output power $P_o$ can be calculated as follows.

$$P_o=17Vrms \times 17Vrms/7\Omega=41.3W$$

Therefore, each of a loss Pr (DC) when the power supply voltage supplied to the amplifier is a constant value (25V) and a loss Pr (stepwise) when the power supply voltage supplied to the amplifier changes in a stepwise manner is calculated as follows.

$$Pr(DC)=60.7W-41.3W=19.4W$$

$$Pr(stepwise)=55.6W-41.3W=14.3W$$

In addition, each of an efficiency η (DC) when the power supply voltage supplied to the amplifier is a constant value (25V) and an efficiency η (stepwise) when the power supply voltage supplied to the amplifier changes in a stepwise manner is calculated as follows.

$$\eta(DC)=41.3W/60.7W=68\%$$

$$\eta(stepwise)=41.3W/55.6W=74\%$$

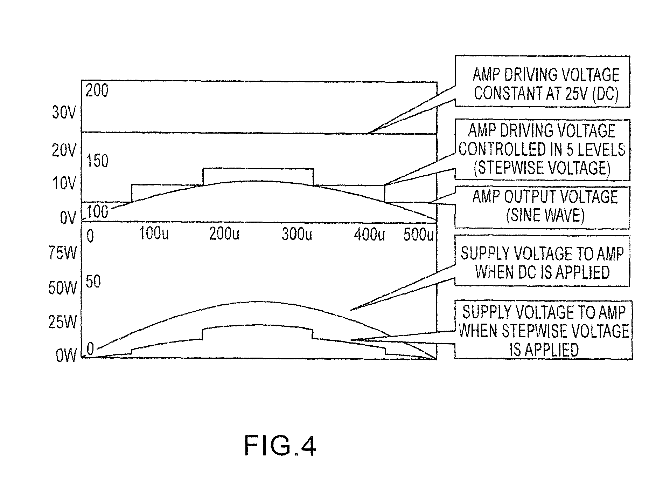

Fig. 4 is a diagram (2) showing the results of a simulation of power supplied to the amplifier under the condition that the power supply voltage supplied to the amplifier changes in a stepwise manner and under the condition that the power supply voltage supplied to the amplifier is constant (25V).

Fig. 4 assumes that the maximum amplitude of the input signal of the amplifier (output of the signal source) is approximately half of the maximum value of the voltage that can be output from the power supply circuit.

Given that the effective value $V_o$ of the input signal of the amplifier is 8Vrms and the load resistance of the amplifier is 7Ω, the current Io flowing into the amplifier is 8Vrms/7Ω.

According to the above equation (1), each of the supplied power P (DC) in a case of the power supply voltage supplied to the amplifier being a constant value (25V) and the supplied power P(stepwise) in a case of the power supply voltage supplied to the amplifier changing in a stepwise manner is calculated as follows.

P(DC)=28.6W

P(stepwise) = 14.8W

According to the above equation (2), the output power Po can be calculated as follows.

$$P_o=8Vrms \times 8Vrms/7\Omega=9.1W$$

Therefore, each of a loss Pr (DC) when the power supply voltage supplied to the amplifier is a constant value (25V) and a loss Pr (stepwise) when the power supply voltage supplied to the amplifier changes in a stepwise manner is calculated as follows.

$$Pr(DC)=28.6W-9.1W=19.5W$$

$$Pr(stepwise)=14.8W-9.1W=5.7W$$

In addition, each of an efficiency η(DC) when the power supply voltage supplied to the amplifier is a constant value (25V) and an efficiency η (stepwise) when the power supply voltage supplied to the amplifier changes in a stepwise manner is calculated as follows.

$$\eta(DC)=9.1W/28.6W=32\%$$

$$\eta(stepwise)=9.1W/14.8W=61\%$$

As seen in the above, under the assumption that the maximum amplitude of the input signal of the amplifier (output of the signal source) is approximately the same as the maximum value of the voltage that can be output from the power supply circuit, if the power supply voltage supplied to the amplifier is changed in a stepwise manner, the efficiency is improved for 6% (74%-68%) compared with the case that the power supply voltage supplied to the amplifier is constant.

Furthermore, under the assumption that the maximum amplitude of the input signal of the amplifier (output of the signal source) is approximately half of the maximum value of the voltage that can be output from the power supply circuit, if the power supply voltage supplied to the amplifier is changed in a stepwise manner, the efficiency is improved for 29% (61%-32%) compared with the case that the power supply voltage supplied to the amplifier is constant.

In other words, by supplying the power supply voltage to an amplifier that rarely outputs a large value using the power supply circuit of the present embodiment, a great improvement of the efficiency of the amplifier can be achieved. As shown in Fig. 2, each of the diodes 17-1, 17-2, 17-3, 17-4 protects the respective DC voltage supplies 15-1- 15-4 by preventing the current from flowing back to the respective switches 16-1 - 16-4 and flowing ultimately to the corresponding DC voltage supplies 15-1 - 15-4 if the respective switches 16-1 and 16-4 are allowed to conduct. In addition, diode 22 prevents current from flowing back to the DC power supply 21.

As previously discussed, if the output voltage of the signal source 13 is equal to or higher than the output threshold voltage of the DC voltage supply 23-3 but lower than the output threshold voltage of the DC voltage supply 23-4, then the voltage output by the DC voltage supply 15-3 (20V) can be supplied to the amplifier 12 as a power supply voltage. In this case, the output voltage of the signal source 13 would be greater than the output threshold voltages of each of the DC voltage supplies 23-1, 23-2 and 23-3. Therefore, the output voltage of the signal source 13 would be greater than the thresholds of each of the comparators 24-1, 24-2 and 24-3 and each of the switches (transistors) 16-1, 16-2 and 16-3 would be set to conduct. However, diodes 17-1 and 17-2 would prevent the current flowing from the DC voltage supply 15-3 to the load device (amplifier 12) from flowing back through the switches (transistors) 16-1 and 16-2 and to the DC voltage supplies 15-1 and 15-2, respectively. In addition, diode 17-4 would prevent current from flowing back to switch (transistor) 16-4. However, since switch (transistor) 16-4 is not set to conduct, diode 17-4 may be omitted.

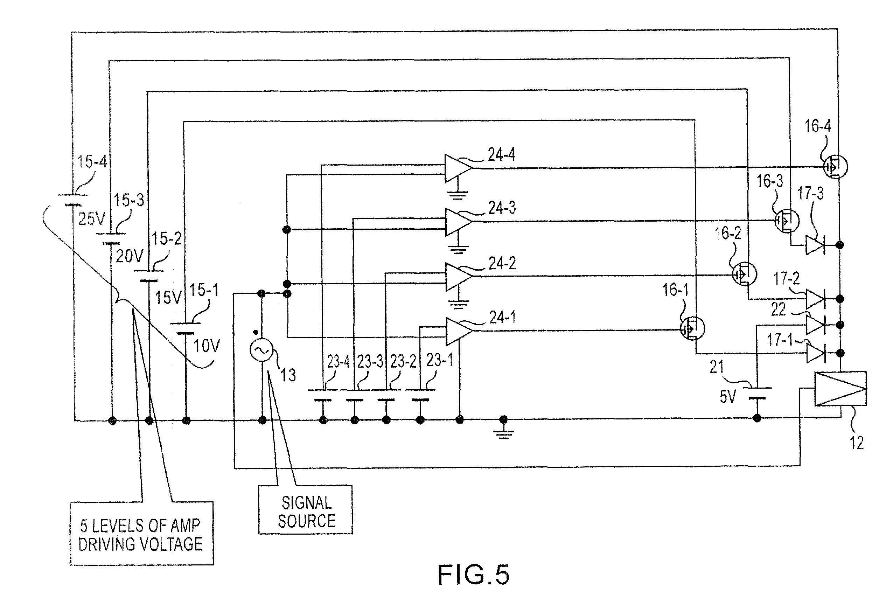

Fig. 5 shows a first modification of the configuration of the controller 14 of Figs. 1 and 2. In Fig. 5, compared with Fig. 2, the diode 17-4 has been omitted, since the power supply circuit according to the first embodiment is able to operate without the diode 17-4. That is, the switch (transistor) 16-4 is switched to conduct only when the output voltage of the signal source 13 is greater than the threshold of the DC voltage supply 23-4. In this case, the current flows from the DC voltage supply 15-4 to the load 12 via switch (transistor) 16-4. In the other cases, when the output voltage of the signal source 13 is lower than the threshold of the DC voltage supply 23-4, the switch (transistor) 16-4 is not switched to conduct (open) and therefore the current is precluded from following back to the DC voltage supply 15-4 by the switch (transistor) 16-4.

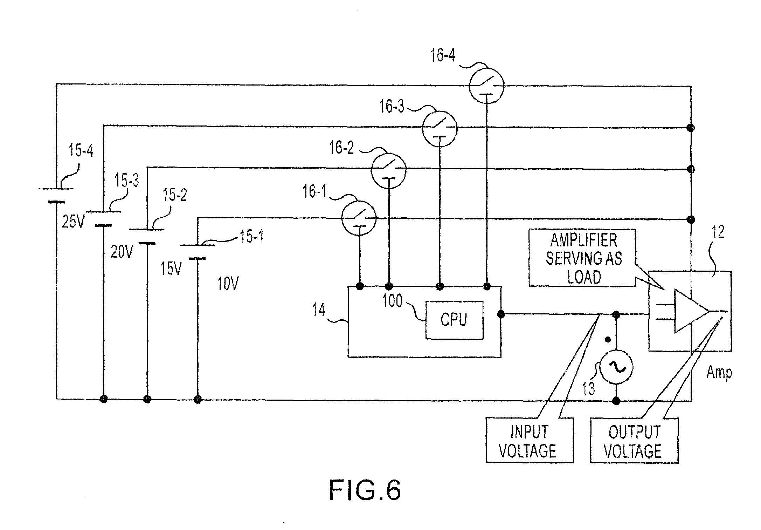

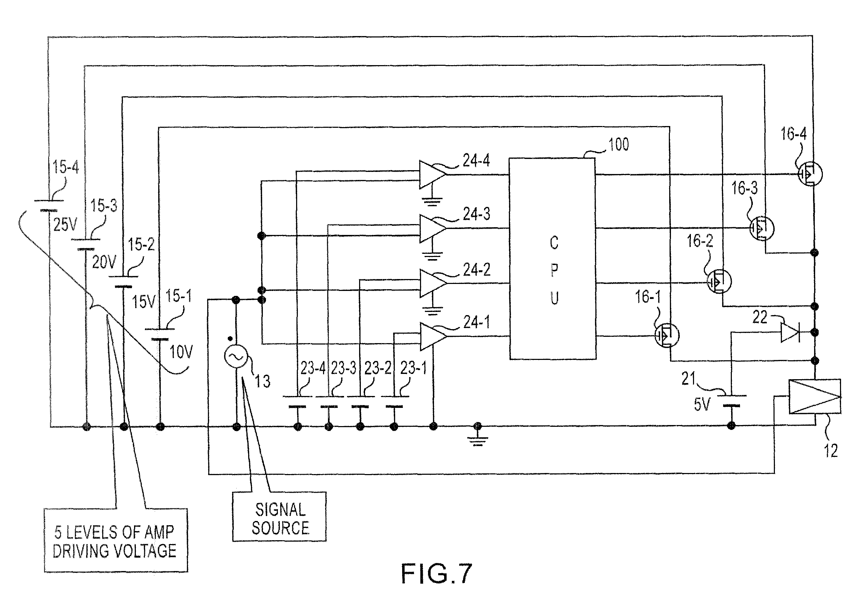

Fig. 6 and 7 shows a second modification of the configuration of the controller 14 of Figs. 1 and 2, respectively. In Figs. 6 and 7, compared with Figs. 1 and 2, the controller 14 includes a central processing unit (CPU) 100, but diodes 17-1 - 17-4 have been omitted. The CPU 100 monitors the output of each of the comparators 24-1 - 24-4 and based on such outputs selects a single switch (transistor) to conduct and prohibits the remaining switches from conducting, or prohibits all the switches from conducting. Therefore, the diodes 17-1 - 17-4 are not necessary, since while current flows through the selected switch, the remaining non-selected switches block the current from flowing back to and damaging the respective DC voltage supplies.

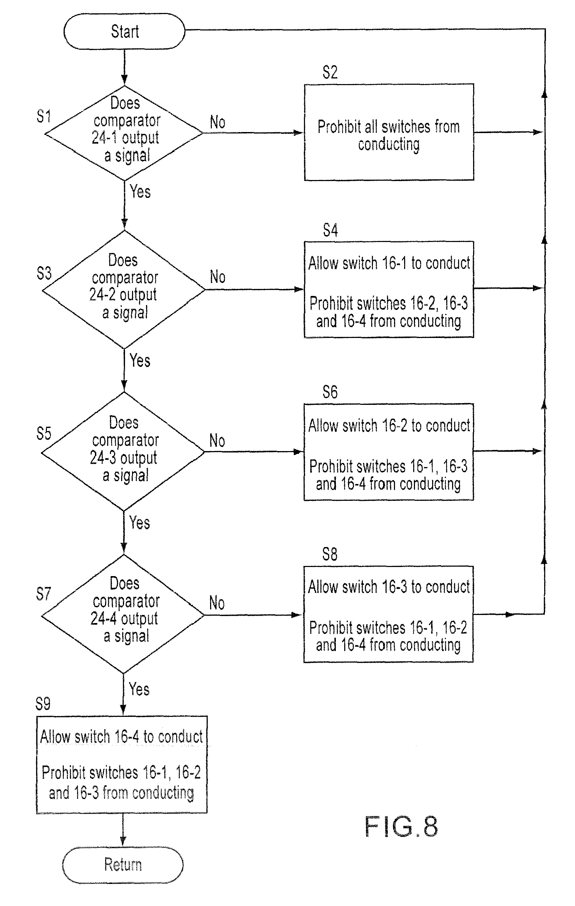

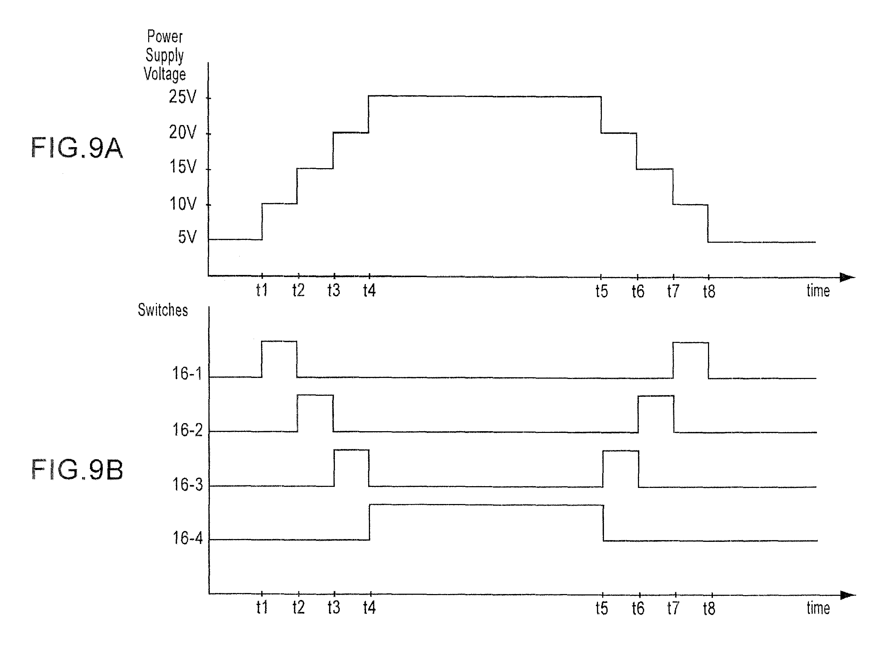

When the voltage that the signal source 13 outputs gradually increases, the power supply circuit performs the following operations. For example, as illustrated in Fig. 8, in step S1, the CPU 100 determines whether the comparator 24-1 outputs a signal (whether the output voltage of the signal source 13 is equal to or higher than the output threshold voltage of the DC voltage supply 23-1). If the comparator 24-1 does not output a signal, the CPU 100 in step S2 prohibits all of the switches 16-1-16-4 from conducting and the default voltage (5V) output by the DC voltage supply 21 is supplied to the load device (amplifier 12) as a power supply voltage. For example, as shown in the timing diagram of Fig. 9 before time $t_1$, the default voltage (5V) is supplied as the power supply voltage to the load device (amplifier 12).

If the comparator 24-1 does output a signal, then the CPU 100 determines in step S3 whether the comparator 24-2 outputs a signal (whether the output voltage of the signal source 13 is equal to or higher than the output threshold voltage of the DC voltage supply 23-2). If comparator 24-2 does not output a signal, then in step S4 the CPU 100 sends a signal to switch 16-1 to allow it to conduct and sends a signal to each of the remaining switches 16-2, 16-3 and 16-4 to prohibit them from conducting. For example, as shown in the timing diagram of Fig. 9, at time $t_1$, when the switch 16-1 is set to conduct, the 10V output voltage of the DC voltage supply 15-1 is supplied as the power supply voltage to the load device (amplifier 12).

If the CPU 100 determines in step S3 that the comparator 24-2 does output a signal, then the CPU 100 determines in step S5 whether comparator 24-3 outputs a signal (whether the output voltage of the signal source 13 is equal to or higher than the output threshold voltage of the DC voltage supply 23-3). If the comparator 24-3 does not output a signal, then in step S6 the CPU 100 sends a signal to switch 16-2 to allow it to conduct and sends a signal to each of the remaining switches 16-1, 16-3 and 16-4 to prohibit them from conducting. For example, as shown in the timing diagram of Fig. 9, at time $t_2$ when the switch 16-2 is set to conduct, the 15V output voltage of the DC voltage supply 15-2 is supplied as the power supply voltage to the load device (amplifier 12).

If the CPU 100 determines in step S5 that the comparator 24-3 does output a signal, then the CPU determines in step S7 whether comparator 24-4 outputs a signal (whether the output voltage of the signal source 13 is equal to or higher than the output threshold voltage of the DC voltage supply 23-4). If comparator 24-4 does not output a signal, then in step S8 the CPU 100 sends a signal to switch 16-3 to allow it to conduct and sends a signal to each of the remaining switches 16-1, 16-2 and 16-4 to prohibit them from conducting. For example, as shown in the timing diagram of Fig. 9, at time $t_3$ when the switch 16-3 is set to conduct, the 20V output voltage of the DC voltage supply 15-3 is supplied as the power supply voltage to the load device (amplifier 12).

However, unlike the power supply circuit of Fig. 2, when the 20V output voltage of the DC voltage supply 15-3 is supplied as the power supply voltage to the load device (amplifier 12) only switch 16-3 is set to conduct. Therefore, diodes 17-1 and 17-2 are not needed in Fig. 7 to prevent the current flowing from the DC voltage supply 15-3 to the load device (amplifier 12) from flowing back through to the respective DC voltage supplies 15-1 and 15-2, since the switches (transistors) 16-1 and 16-2 do not conduct.

If the CPU 100 determines in step S7 that the comparator 24-4 does output a signal, then in step S9 the CPU 100 sends a signal to switch 16-4 to allow it to conduct and sends a signal to each of the remaining switches 16-1, 16-2 and 16-3 to prohibit them from conducting. For example, as shown in the timing diagram of Fig. 9, at time $t_4$ when the switch 16-4 is set to conduct, the 25V output voltage of the DC voltage supply 15-4 is supplied as the power supply voltage to the load device (amplifier 12).

Additionally, when the voltage output by the signal source 13 gradually decreases, the power supply circuit performs the following operations. For example, when the CPU 100 determines that the comparator 24-4 no longer outputs a signal in step S7, the CPU 100 in step S8 sends a signal to switch 16-3 to allow it to conduct and sends a signal to each of the remaining switches 16-1, 16-2 and 16-4 to prohibit them from conducting. For example, as shown in the timing diagram of Fig. 9, at time $t_5$ when the switch 16-3 is set to conduct, the 20V output voltage of the DC voltage supply 15-3 is supplied as the power supply voltage to the load device (amplifier 12).

Next, when the CPU 100 determines that the comparator 24-3 no longer outputs a signal in step S5, the CPU 100 in step S6 sends a signal to switch 16-2 to allow it to conduct and sends a signal to each of the remaining switches 16-1, 16-3 and 16-4 to prohibit them from conducting. For example, as shown in the timing diagram of Fig. 9, at time $t_6$ when the switch 16-2 is set to conduct, the 15V output voltage of the DC voltage supply 15-2 is supplied as the power supply voltage to the load device (amplifier 12).

Next, when the CPU 100 determines that the comparator 24-2 no longer outputs a signal in step S3, the CPU 100 in step S4 sends a signal to switch 16-1 to allow it to conduct and sends a signal to each of the remaining switches 16-2, 16-3 and 16-4 to prohibit them from conducting. For example, as shown in the timing diagram of Fig. 9, at time $t_7$ when the switch 16-1 is set to conduct, the 10V output voltage of the DC voltage supply 15-1 is supplied as the power supply voltage to the load device (amplifier 12).

Finally, when the CPU 100 determines that the comparator 24-1 no longer outputs a signal in step S1, the CPU 100 in step S2 sends a signal to each of the switches 16-1, 16-2, 16-3 and 16-4 to prohibit them from conducting. For example, as shown in the timing diagram of Fig. 9, at time $t_8$ when none of the switches conduct, the 5V output default voltage of the DC voltage supply 21 is supplied as the power supply voltage to the load device (amplifier 12).

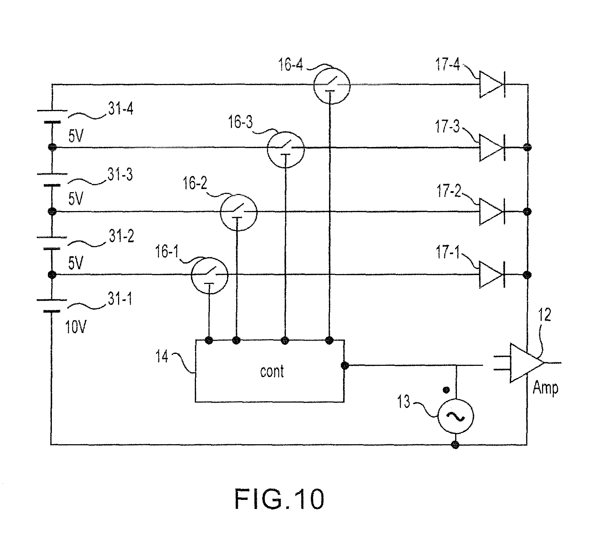

Fig. 10 is a diagram of an overview configuration of the power supply circuit relating to the second embodiment of the present invention.

In the first embodiment, the DC voltage supplies 15-1, 15-2, 15-3 and 15-4 are arranged in parallel. However, in the second embodiment, the DC voltage supplies 31-1, 31-2, 31-3 and 31-4 are loaded in series. As a result, it is possible to the use efficiency of the DC voltage supply.

Because operations of the switches 16-1, 16-2, 16-3 and 16-4 and the controller 14 are the same as those in the first embodiment, the explanations are omitted.

Further, as shown in Fig. 10, the second embodiment, like the first embodiment, also includes diodes 17-1, 17-2, 17-3, 17-4 each of which protects the respective DC voltage supplies 31-1 - 31-4 by preventing the current from flowing back to the respective switches 16-1 - 16-4 and flowing ultimately to the corresponding DC voltage supplies 15-1 - 15-4 if the respective switches 16-1 and 16-4 are allowed to conduct.

However, in the second embodiment, the diodes 17-1, 17-2 and 17-3 provide the additional function of preventing a short circuit if more than one of the switches 16-1-16-4 are set to conduct. For example, if the output voltage of the signal source 13 is equal to or higher than the output threshold voltage of the DC voltage supply 23-3, then the voltage output by the DC voltage supply 31-3 (20V) can be supplied to the amplifier 12 as a power supply voltage. In this case, the output voltage of the signal source 13 would be greater than the output threshold voltages of each of the DC voltage supplies 23-1, 23-2 and 23-3. Therefore, the output voltage of the signal source 13 would be greater than the thresholds of each of the comparators 24-1, 24-2 and 24-3 and each of the switches (transistors) 16-1, 16-2 and 16-3 would be set to conduct. However, if diodes 17-1 and 17-2 were omitted from the power supply circuit, then the 10V from the power supply 31-1 would be supplied as the power supply voltage to the load (amplifier 12) instead of the 20V from the DC voltage supply 31-3, since switch 16-1 would be closed, which would cause a short circuit from the DC power supply voltage 31-1 to the load (amplifier 12). In other words, in the example shown in Fig. 10, without diodes 17-1 - 17-3, the power supply voltage would always be 10V from the DC voltage supply 31-1.

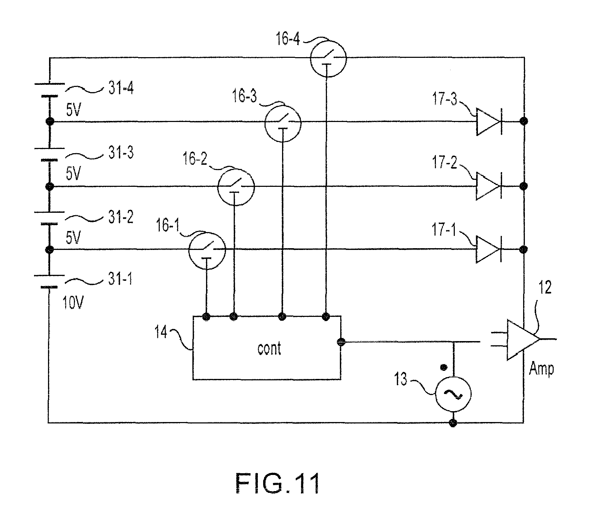

Fig. 11 shows a first modification (1) of the second embodiment of the present invention. In Fig. 11 compared with Fig. 10, the diode 17-4 has been omitted, since the power supply circuit according to the second embodiment is able to operate without the diode 17-4. That is, the switch (transistor) 16-4 is switched to conduct only when the output voltage of the signal source 13 is greater than the threshold of the DC voltage supply 23-4. In this case, the current flows from the DC voltage supply 31-4 to the load 12. In the other cases, when the output voltage of the signal source 13 is lower than the threshold of the DC voltage supply 23-4, the switch (transistor) 16-4 is not switched to conduct (open) and therefore the current is precluded from following back to and damaging the DC voltage supply 31-4 by the switch (transistor) 16-4.

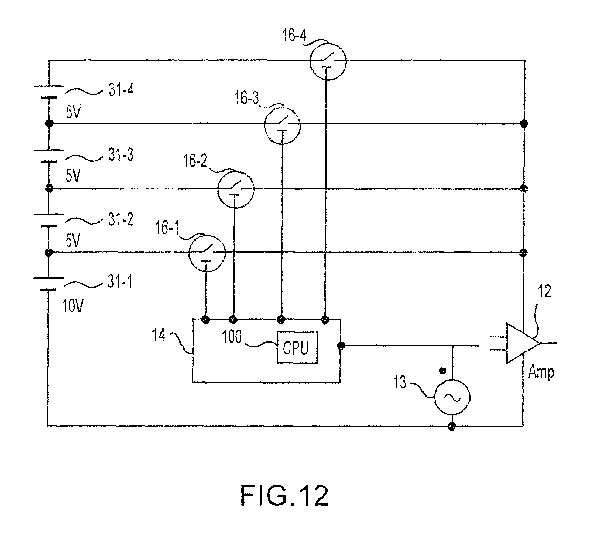

Fig. 12 shows a second modification (2) of the second embodiment of the present invention. In Fig. 12, compared with Figs. 10 and 11, the controller 14 includes a central processing unit (CPU) 100, but the diodes 17-1 - 17-4 have' been omitted. Because operations of the CPU 100 and the switches 16-1 - 16-4 are the same as those in the first embodiment, the explanations are omitted.

Note that in the power supply circuit of the present embodiment, there is a problem that even when the power supply voltage supplied to the amplifier is switched to decrease in a stepwise manner as the voltage input to the amplifier decrease, the power supply voltage supplied to the amplifier is maintained due to the capacity of the amplifier, and the amplifier is burdened with the decreased amount of the extra voltage.

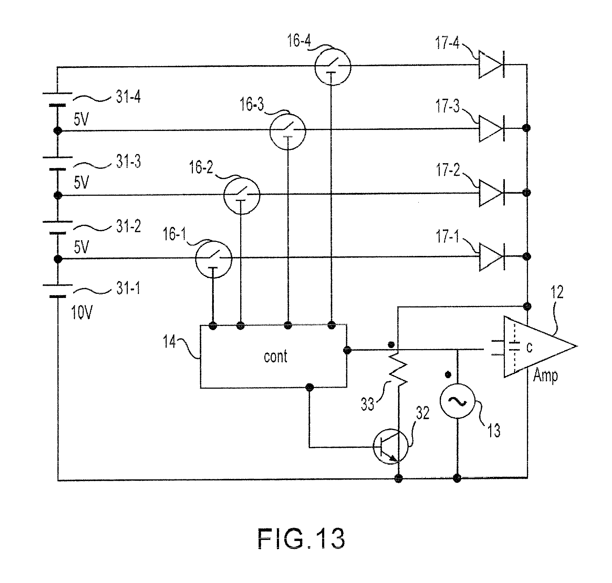

in the following description, the solution of the problem is explained with reference to Fig. 13-Fig. 16.

Fig. 13 shows a modification example (3) of the power supply circuit of the second embodiment according to the present invention.

In the power supply circuit shown in Fig. 13, a load resistor 33 and a switch (transistor) 32 are added in order to adjust the power supply voltage supplied to the amplifier 12.

The controller 14 additionally comprises a determination circuit (not showm in the drawing) for determining whether the power supply voltage supplied to the amplifier 12 is decreased or not by referencing to outputs of the comparator 24-1, 24-2, 24-3 and 24-4, for example. When the determination circuit determines that the power supply voltage supplied to the amplifier 12 is decreased, by allowing the switch 32 to conduct, the power supply voltage supplied to the amplifier 12 is consumed by the load resistor 33.

As described above, when the determination circuit determines that the power supply voltage supplied to the amplifier 12 is decreased, by removing the power supply voltage supplied to the amplifier 12, it is possible to prevent the power supply voltage from being maintained due to the capacity C (shown by the dashed lines in Fig. 13) of the amplifier 12.

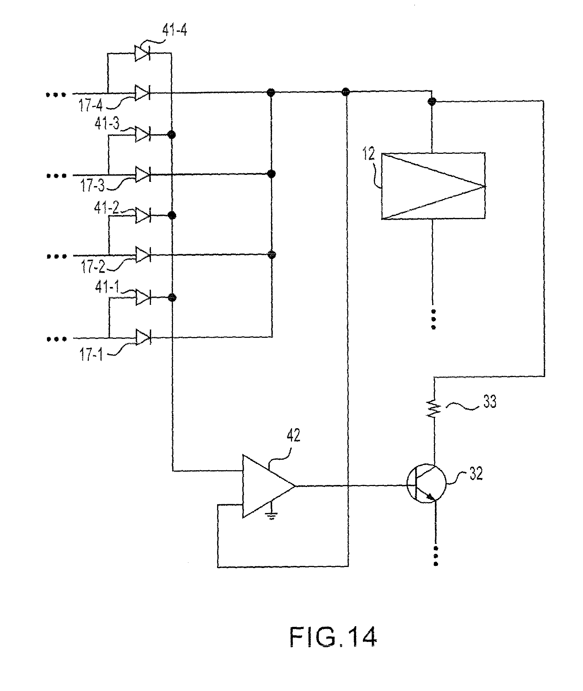

Alternatively, diodes 41-1, 41-2, 41-3 and 41-4 provided respectively in parallel to the diodes 17-1, 17-2, 17-3 and 17-4 and a comparator 42 can be added instead of adding the determination circuit in the controller 14 as shown in Fig. 14.

In such a case, the comparator 42 compares a power supply voltage that went through the diodes 41-1 41-2, 41-3 and 41-4 (a first power supply voltage) with a power supply voltage in the input side of the amplifier 12 (a second power supply voltage), determines that the power supply voltage supplied to the amplifier 12 is decreased if the first power supply voltage closer to the DC voltage supplies 31-1, 31-2, 31-3 and 31-4 is smaller than the second power supply voltage, and outputs a signal to operate the switch 32. As a result, the power supply voltage supplied to the amplifier 12 can be consumed by the load resistor 33.

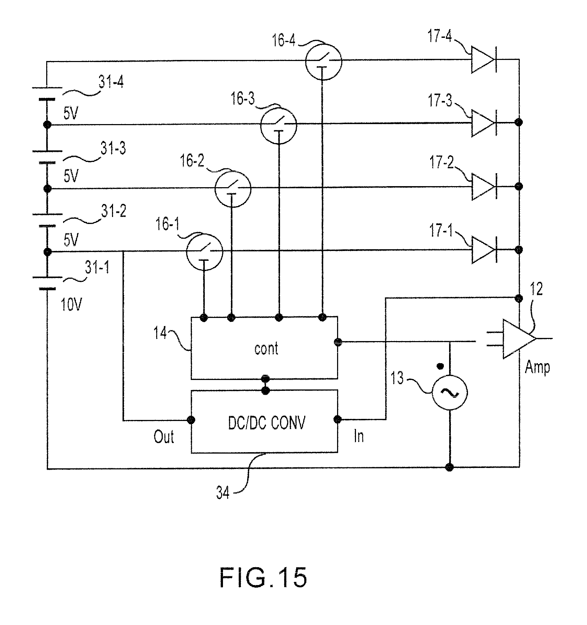

Fig. 15 shows a modification example (4) of the power supply circuit of the second embodiment according to the present invention.

In the power supply circuit shown in Fig. 15, a DC/DC converter 34 is added in order to increase the power supply voltage supplied to the amplifier 12. The DC/DC converter 34 sends back the increased power supply voltage of the amplifier 12 to the controller 14 to be used as one of the DC voltage supplies.

According to the above example, when it is determined that the power supply voltage supplied to the amplifier 12 is decreased, it is possible to remove the power supply voltage supplied to the amplifier 12, and therefore, it is possible to prevent the power supply voltage from being maintained due to the capacity of the amplifier 12.

Note that in Fig. 15, the DC/DC converter 34 increases the power supply voltage supplied to the amplifier 12 to the value slightly larger than the voltage value that the DC voltage supply 31-1 generates (10V) and outputs the voltage. Consequently, when the switch (transistor) 16-1 is operated, the output of the DC/DC converter 34 is used as the power supply voltage.

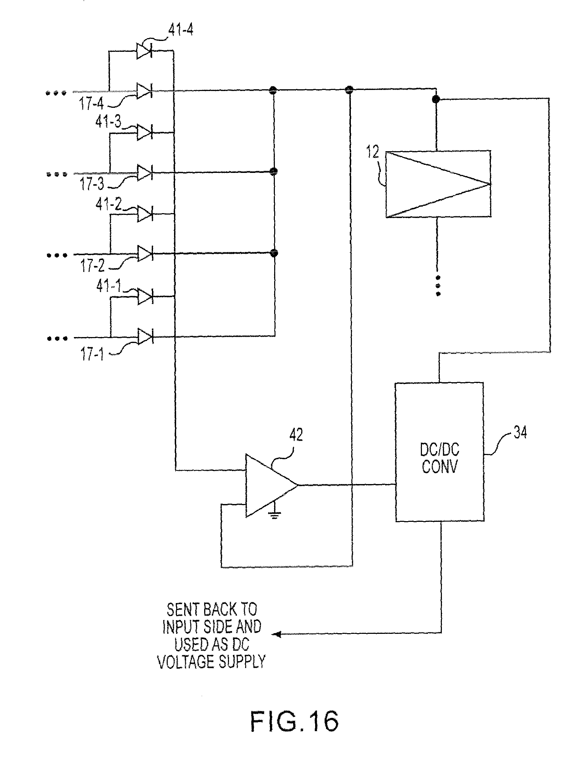

Fig. 16 is a diagram showing further details of the main part of Fig. 15.

The operations of the diodes 41-1, 41-2, 41-3 and 41-4 and the comparator 42 in Fig. 16 are the same as those in Fig. 14, and therefore the explanations are omitted.

In Fig. 16, the comparator 42 compares a power supply voltage that went through the diodes 41-1 41-2, 41-3 and 41-4 (a first power supply voltage) with a power supply voltage in the input side of the amplifier 12 (a second power supply voltage), determines that the power supply voltage supplied to the amplifier 12 is decreased if the first power supply voltage closer to the DC voltage supplies 31-1, 31-2, 31-3 and 31-4 is smaller than the second power supply voltage, and outputs a signal to start the DC/DC converter 34. As a result, it is possible to further remove the power supply voltage supplied to the amplifier 12 via the DC/DC converter 34.

It should be noted that in the explanation above, the number of the DC voltage supplies is four; however, the number of the DC voltage supplies can be any number that is two and above.

The configurations additionally explained in Fig. 13-Fig. 16 can be implemented in the power supply circuit of the first embodiment as well as the power supply circuit of the second embodiment.

In any of the above aspects, the various features may be implemented in hardware, or as software modules running on one or more processors. Features of one aspect may be applied to any of the other aspects.

The invention also provides a computer program or a computer program product for carrying out any of the methods described herein, and a computer readable medium having stored thereon a program for carrying out any of the methods described herein. A computer program embodying the invention may be stored on a ccmputer-readable medium, or it could, for example, be in the form of a signal such as a downloadable data signal provided from an Internet website, or it could be in any other form.

**Claims**

1. A power supply device supplying a power supply voltage to a load device such as an amplifier, comprising:

   control means for controlling the power supply voltage supplied to the load device variably in a stepwise manner in accordance with an input or output voltage of the load device.

2. The power supply device according to claim 1, wherein
   the control means comprises a plurality of DC voltage supplies arranged in parallel and a plurality of corresponding switches for switching the plurality of DC voltage supply arranged in parallel in accordance with the input or output voltage of the load device.

3. The power supply device according to claim 1, wherein
   the control means comprises a plurality of DC voltage supplies arranged in series and a plurality of corresponding switches for switching a plurality of DC voltage obtained from the plurality of DC voltage supplies arranged in series in accordance with the input or output voltage of the load device.

4. The power supply device according to claims 2 or 3, wherein
   the control means comprises a plurality of diodes, each input of which is connected to one of the output ends of the plurality of switches and outputs of which are in a common connection, connected to the load device.

5. The power supply device according to claim 2 or 3, wherein
   the control means comprises a switch control circuit of the plurality of switches, and
   the switch control circuit comprises a plurality of comparators, each first input of which is connected to the input or output voltage of the load device, each second input of which is connected to one of a plurality of corresponding constant voltage supplies, and each output of which is connected to a control end of one of the plurality of switches.

6. The power supply device according to any one of the preceding claims, further comprising:

   determination means for determining whether or not a power supply voltage of the load device is decreased; and

adjustment means for adjusting the power supply voltage of the load device via a load resistor when it is determined that the power supply voltage of the load device is decreased.

7. The power supply device according to any one of claims 2 to 5, further comprising:

determination means for determining whether or not a power supply voltage of the load device is decreased; and a converter for increasing the power supply voltage of the load device and for sending back the power supply voltage of the load device to be used as one of the DC voltage supplies when it is determined that the power supply voltage of the load device is decreased.

8. The power supply device according to claim 2 or 4 to 7, wherein each of said plurality of DC voltage supplies arranged in parallel supply a different voltage and for the DC voltage supply that supplies the highest voltage, the output of the corresponding switch is connected directly to the load device.

9. The power supply device according to claim 3 or 4 to 7, wherein each of said plurality of DC voltage supplies arranged in series supply a different voltage and for the DC voltage supply that supplies the highest voltage, the output of the corresponding switch is connected directly to the load device.

10. The power supply device according to claim 8 or 9, wherein the control means further comprises a plurality of diodes, each input of which is connected to one of the output ends of the remaining plurality of switches and outputs of which are in a common connection, connected to the load device.

11. The power supply device according to claim 8 or 9, wherein the control means comprises a switch control circuit of the plurality of switches, and the switch control circuit comprises a plurality of comparators, each first input of which is connected to the input or output voltage of the load device, each second input of which is connected to one of a plurality of corresponding constant voltage supplies, and each output of which is connected to a control end of one of the plurality of switches.

12. The power supply device according to claim 1, wherein the control means comprises a CPU, a plurality of DC voltage supplies arranged in parallel and a plurality of switches corresponding one to one with said plurality of DC voltage supplies arranged in parallel, wherein said CPU selects a single switch of said plurality of switches at a time to obtain the corresponding DC voltage supply in accordance with the input or output voltage of the load device.

13. The power supply device according to claim 1, wherein the control means comprises a CPU, a plurality of DC voltage supplies arranged in series and a plurality of switches corresponding one to one with said plurality of DC voltage supplies arranged in series, wherein said CPU selects a single switch of said plurality of switches at a time to obtain the corresponding DC voltage supply in accordance with the input or output voltage of the load device.

14. The power supply device according to claim 12 or 13, wherein said control means further comprises a plurality of comparators, each first input of which is connected to the input or output voltage of the load device, each second input of which is connected to one of a plurality of corresponding constant voltage supplies, and each output of which is connected to said CPU.

15. A method of supplying a power supply voltage to a load device for supplying a power supply voltage to a load device such as an amplifier, comprising:

a controlling step of controlling the power supply voltage supplied to the load device variably according to an input or output voltage of the load device.

16. The method of supplying a power supply voltage to a load device according to claim 15, wherein in the control step, the power supply voltage supplied to the load device is controlled variably by switching a plurality of DC voltage supply arranged in parallel in accordances with the input or output voltage of the Load device.

17. The method of supplying a power supply voltage to a load device according to claim 15, wherein

in the control step, the power supply voltage supplied to the load device is controlled variably by switching a plurality of voltages obtained from a plurality of DC voltage supplies arranged in series in accordance with the input or output voltage of the load device.

FIG.1

FIG.2

Vout

12

5V

21

17-4 16-4 17-3 16-3 17-2 22 17-1 16-2 16-1

24-4 24-3 24-2 24-1

23-4 23-3 23-2 23-1

13

SIGNAL SOURCE

5 LEVELS OF AMP DRIVING VOLTAGE

15-4 25V 15-3 20V 15-2 15V 15-1 10V

a'

FIG.3

FIG.4

EP 1 947 833 A2

FIG.5

FIG.6

FIG.7

FIG.8

EP 1 947 833 A2

FIG.9A

FIG.9B

FIG.10

FIG.11

FIG.12

FIG.13

FIG.14

FIG.15

FIG.16

**EP 1 947 833 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2001069241 A